Europäisches Patentamt

(19) European Patent Office

Office européen des brevets

(11) Publication number : **0 564 238 B1**

(12) **EUROPEAN PATENT SPECIFICATION**

(45) Date of publication of patent specification :
06.12.95 Bulletin 95/49

(51) Int. Cl.[6] : **H01L 39/24**

(21) Application number : **93302476.2**

(22) Date of filing : **30.03.93**

(54) **Superconducting film and process for production thereof.**

(30) Priority : **31.03.92 JP 75050/92**

(43) Date of publication of application :
06.10.93 Bulletin 93/40

(45) Publication of the grant of the patent :
06.12.95 Bulletin 95/49

(84) Designated Contracting States :
**BE DE FR GB SE**

(56) References cited :
**WO-A-90/04856**
**SUPERCONDUCTOR SCIENCE AND**
**TECHNOLOGY, vol. 2, no. 5, November 1989,**
**LONDON, UK, pages 274-278; Dou S.X. et al.:**
**'Superconductivity in the Bi-Pb-Sr-Ca-Cu-O**
**system with oxide additions'**

(56) References cited :
**IEEE TRANSACTIONS ON MAGNETICS, vol.**
**27, no. 2, March 1991, pages 2202-5, New York,**
**US, & APPLIED SUPERCONDUCTIVITY CON-**
**FERENCE, 24 Sept. 1990, Snowmass, US;**
**Hoshino K. et al.:** "**Magnetic shield of high-Tc**
**BiPbSrCaCuO superconductors at 77K for**
**SQUID measurement**"

(73) Proprietor : **NGK INSULATORS, LTD.**
**2-56, Suda-cho, Mizuho-ku**
**Nagoya City Aichi Pref. (JP)**

(72) Inventor : **Shimizu, Hideki**
**205, NGK Minamisyataku 15,**
**Takeda-cho 2-chome**
**Mizuho-ku, Nagoya City, Aichi Pref.,467 (JP)**
Inventor : **Watanabe, Shingo**
**9-24 Shimosazarai-cho**
**Yokkaichi-city, Mie-Prefecture, 512 (JP)**

(74) Representative : **Paget, Hugh Charles Edward**
**et al**
**MEWBURN ELLIS**
**York House**
**23 Kingsway**
**London WC2B 6HP (GB)**

EP 0 564 238 B1

## Description

## Background of the Invention

The present invention relates to a superconducting device comprising at least a substrate and a superconducting layer, and processes for production thereof. The superconducting device for magnetic shielding according to the present invention can be suitably used as a material for magnetic shielding capable of forming a low magnetic space required by a superconducting quantum interference device (SQUID) as a sensitive fluxmeter.

Application of the SQUID as a sensitive fluxmeter to medical treatment is drawing attention. The SQUID has such a high sensitivity as to enable detection of a very weak magnetic field of $10^{-8}$ G order generated by a brain of living body and may therefore be able to form an image of the section of said brain utilizing said magnetic field. To use a SQUID for these applications, however, it is necessary to shield a SQUID from geomagnetism or urban magnetic noise each having a magnetic flux density of $0.1$ G or more and thereby form a low magnetic space having a magnetic filed of $10^{-8}$ G or less. Hence, active researches and developments are under way on a device for magnetic shielding having such a magnetic shieldability as to enable reduction of external magnetic flux density by at least $10^8$.

Spaces surrounded by a ferromagnetic metal such as Permalloy, ferrite or the like have hitherto been utilized for magnetic shielding. Further in recent years, there have been proposed a number of apparatuses for magnetic shielding, utilizing the Meissner effect of a superconducting material. Oxide high-temperature superconducting materials, including Bi-type superconductors, for example, Bi-Sr-Ca-Cu-O type oxides, are drawing attention for their application to the magnetic shielding mentioned above. There have been found various Bi-based oxides consisting of the same elements but having different compositions. Further, active researches are under way in order to replace the given proportions of some of the elements (e.g. Ca, Sr) in the above oxides, with other element(s) to obtain oxides of superior properties, as seen in, for example, Japanese Patent Application Kokai (Laid-Open) Nos. 215720/1989 and 307827/1990.

An example of the application of an oxide superconducting material to magnetic shielding is described in Japanese Patent Laid-Open No. 134998/1989, wherein an oxide superconducting material is arranged in the innermost side of a space to be subjected to magnetic shielding. Further, Japanese Patent Application No. 97197/1989 describes a device for magnetic shielding comprising at least a substrate and a superconducting layer with the substrate arranged closer to a magnetic source from which shielding must be made. Further, Japanese Patent Application No. 323415/1991 describes a tubular superconducting device for magnetic shielding integrally formed by bonding parts each having a laminated structure consisting of at least a substrate and an oxide superconducting layer.

Devices for magnetic shielding, however, are still in development stage. For example, a biomagnetism analyzer using a SQUID may require a room or a space as large as several square meters under magnetic shielding, and actual production of such a large device for magnetic shielding involves technical difficulties, and many problems must be solved before the production.

Particularly important of these problems is the formation of through holes of small diameter similar to pin holes in the oxide superconducting layer of device for magnetic shielding. These through holes may be formed due to the presence of impurities, very small foreign matters, etc., and obviously no superconducting material is present in these through holes. Such through holes bring about the leakage of magnetic field therethrough and adversely affects the magnetic shielding effect. For example, when a through hole having a diameter at least $20$ μm is present in a superconducting layer having a thickness of $100$ μm of a device for magnetic shielding, the spaces in the through holes and the vicinities thereof are unable to achieve a magnetic shieldability of $10^8$ or more. In large superconducting devices for magnetic shielding, such as a device used for a biomagnetism analyzer using a SQUID or for a room under magnetic shielding, it is technically very difficult to prevent flaws such as very small through holes and the like from occurring. When a tubular device for magnetic shielding has a tubular wall, one open end, and one closed end, and when magnetic field leaks through the device distant from the open end of the device, spaces, which suppose to have a higher magnetic shielding effect in the device, does not have the desired shielding effect, and thus the tubular device may have a critical drawback as a practical product.

The size of magnetic field in through holes and vicinities thereof varies depending upon the diameters of through holes and the thickness of oxide superconducting layer. Therefore, when the thickness of superconducting layer is sufficiently large as compared with the diameters of through holes, the leakage of magnetic field via through holes can be negligible. For example, in order to achieve a magnetic shieldability of $10^8$ or more, that is a magnetic field inside the device is smaller by one $10^8$th of a magnetic field outside of the device, by a device for magnetic shielding having a superconducting layer of $300$ μm in thickness, the presence of through holes of about $1\emptyset\emptyset$ μm in diameter is permissible.

Actual formation of an oxide superconducting layer of large thickness is not easy. In Japanese Patent Applicaiton No. 411179/199$\emptyset$, it is described to form an oxide superconducting layer on a tubular substrate by (a) coating a slurry containing oxide powders capable of becoming, uponfired, an oxide superconducting material onto a surface of a tubular substrate, for example, a substrate having a generally cylindrical shape, and then (b) firing the slurry. The maximum thickness of the superconducting layer formed by the above technique, however, is limited to $2\emptyset\emptyset$-$3\emptyset\emptyset$ μm. When the thickness of the coated slurry to be fired is large, the melt of the superconducting oxide dripps during the firing, making the thickness of the oxide superconducting layer nonuniform and consequently the critical current density of the tube is not uniform either. This is a direct reason why the maximum thickness of the superconducting layer in the device is limited. Similarly to ordinary metals, superconducting oxides sharply reduce the viscosities at temperatures close to the melting points; therefore, the slurry containing the superconducting oxides shows sharp viscosity reduction as well at said temperatures; this causes the above-mentioned dripping of the melt of the superconducting oxide. This is a property characteristic of superconducting oxides and not seen in oxides used in glaze for forming glass network structure, and is a biggest obstacle in obtaining an oxide superconducting layer of large thickness. Dripping tends to occur in the firing of, in particular, a large tubular material because the firing of such a material has been conducted by arranging the material with its longitudinal axis aligned in a vertical direction, and no superconducting layer of satisfactory thickness has been obtainable.

## Summary of the Invention

The present inventors made extensive studies and experiments in order to solve the above-mentioned problem peculiar to superconducting oxides, i.e. the sharp viscosity reduction at temperatures close to the melting points. As a result, the present inventors found that addition of magnesium oxide to slurry of superconducting oxide alleviates the sharp viscosity reduction at said high temperatures. The finding has led to the completion of the present invention.

According to the invention, there is provided a superconducting device as set forth in claim 1 which comprises a substrate and a superconducting oxide film thereon.

The superconducting film may comprise grains of a Bi-type superconducting oxide, and paticles containing magnesium dispersed in the grains. Preferably the superconducting film includes $\emptyset.1$ -3 % by weight of magnesium oxide.

In particular, there is provided a superconducting device for magnetic shielding comprising; a substrate; and a superconducting layer supported by the substrate, the superconducting layer including grains of a Bi-type superconducting oxide so that the superconducting layer has a critical temperature higher than -196 °C, the superconducting layer having a thickness in a range from $3\emptyset\emptyset$ to $1,\emptyset\emptyset\emptyset$ μm, the superconducting layer including $\emptyset.1$-5% by weight of magnesium oxide, wherein the superconducting device has a laminated structure including the substrate and the superconducting layer. A superconducting device for magnetic shielding may have a laminated structure. A superconducting layer may include grains of a Bi-type superconducting oxide, and paticles containing magnesium dispersed in the grains.

The present invention further provides a process of producing a superconducting oxide film on a substrate as set forth in claim 7.

In particular the present invention provides a process for producing a superconducting device for magnetic shielding, having a laminated structure consisting of at least a substrate and a superconducting layer, which process comprises firing, on a substrate, a mixture of a calcined powder of superconducting oxide and $\emptyset.1$-5% by weight of a magnesium oxide powder at a temperature at which said superconducting oxide is melted or partially melted, to form a superconducting layer on the substrate.

In the present invention, the device for magnetic shielding is preferably tubular. The process according to the present invention is particularly effective when the firing is conducted by arranging the tubular substrate with its longitudinal axis aligned in a vertical direction.

## Brief Description of the Drawings

Fig. 1 is a graph showing a relation between critical current density Jc (A/cm$^2$) and amount (wt. %) of magnesium oxide added, in a rectangular test piece of $5\emptyset$ mm in length and 5 mm in width having a silver substrate and a superconducting layer of $Bi_2Sr_2CaCu_2O_x$ laminated on the substrate.

Fig. 2 is a graph showing relations between critical current density Jc (A/cm$^2$) and thickness (μm) of superconducting layer in a test piece of $5\emptyset$ mm in length and 5 mm in width having a silver substrate and a superconducting layer of $Bi_2Sr_2CaCu_2O_x$ laminated on the substrate.

Fig. 3 is a graph showing relations between critical current Ic (A/cm) and the thickness ($\mu$m) of superconducting layer, in a cylindrical superconducting device for magnetic magnetic shielding having an outer diameter of $1\emptyset\emptyset$ mm and a height of $1\emptyset\emptyset\emptyset$ mm.

Fig. 4 is a perspective view of an embodiment of a cylindrical superconducting device for magnetic magnetic shielding.

Fig. 5 is an enlarged cross section taken along the line A-A of Fig. 4.

**Detailed Description of the Invention**

The superconducting film of the present invention may have a tubular shape or a flat sheet shape but is not restricted to these shapes. The superconducting device for magnetic shielding according to the present invention, which has a laminated structure consisting of at least a substrate and a superconducting layer, also may have a tubular shape or a flat sheet shape but is not restricted to these shapes.

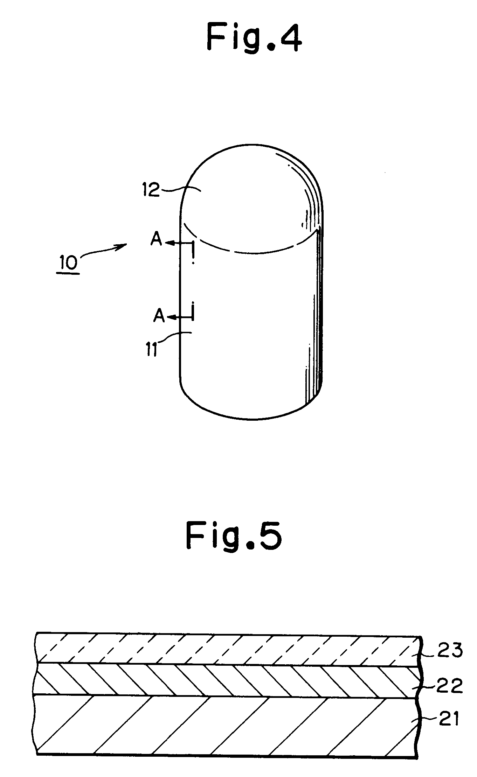

The superconducting device $1\emptyset$ for magnetic shielding according to the present invention may have a tubular wall 11, as shown in Fig. 4. With this shape the superconducting layer 23 may be at the inner side or outer side of the substrate 21. However, the substrate is preferably arranged closer to a magnetic source from which shielding is made. The shape of the tubular device has no particular restriction, and a cylinder, a tetragonal tube, a polygonal tube or the like is appropriately selected depending upon the application purpose, application condition, etc.

Preferably the substrate of the superconducting device has a tubular wall 11, and the wall 11 may have a generally-cylindrical shape. Preferably the substrate has one open end and one close end. The closed end may have a shape of a cap portion 12 protruded from the tubular wall 11. Preferably the cap portion 12 have a laminated sturucture in the same way as the tubular wall 11. The tubular device may have bottom members for the closed end. When the tubular device has one close end, it has a higher magnetic shielding effect than a tubular device of the same tube with two open ends and is preferable. A bottomed tubular device having a small cylinder bonded to the center of the bottom, is also preferable so that cables for transmitting signals from a sensor connected to the sensor inside the tubular device may pass through the small cylinder.

The substrate used in the superconducting device for magnetic shielding may be any substrate as long as it can keep the mechanical strength of the device and support the superconducting layer. The substrate may be, for example, a ceramic such as zirconia, titania, glass or the like; a metal such as SUS $43\emptyset$, SUS $31\emptyset$, SUS $3\emptyset4$, Inconel, Incoloy, Hastelloy or the like; or a noble metal such as gold, silver, platinum or the like. The substrate may also be a laminate or composite of said materials.

In the suercondcuting device for magnetic shielding according to the present invention, when the substrate 21 and the superconducting layer 23 may react with each other (for example, the substrate is Inconel and the supercondcuting layer is $Bi_2Sr_2CaCu_2O_x$), it is necessary to arrange an intermediate medium 22 between the substrate and the superconducting layer to prevent the reaction between them. The intermediate medium is preferably, for example, a noble metal such as silver or the like. The intermediate medium may consist of two layers which may be a noble metal layer and a glass layer with the glass arranged adjacent to the substrate because the glass can function also as an adhesive between the substrate and the noble metal. In this case, it is particularly preferable to arrange the glass layer between the substrate and the nobel metal layer in the shape of stripes, dots, or lattice or in a random shape. This partial arrangement of glass is preferable because it can relax, in a cold-hot cycle, the thermal shock which the superconducting layer formed on the noble metal, or the tubular superconducting device itself for magnetic shielding undergoes and, as a result, the superdonducting device can maintain its magnetic shieldability stably.

The superconducting composition used as an superconducting layer in the present invention has no particular restriction. It is, for example, a Bi-based superconducting oxide represented by $Bi_2Sr_2CaCu_2O_x$, $Bi_2Sr_2Ca_2Cu_3O_x$, etc.

Another example of the main component of the superconducting composition used as an superconducting layer in the present invention is a rare earth-based superconducting oxide represented by $REBa_2Cu_3O_{7-y}$, (RE is a rare earth element and comprises at least one element selected from the group consisting of Y, Gd, Dy, Ho, Er and Yb). The superconducting composition containing this rare earth-based superconducting oxide as the main component can be used preferably. In the above formula, y, which may be any value of $\emptyset$-1 because the oxygen contents in individual raw material oxides are independent and have no stoichiometrical relation with each other, has direct influence on the superconductivity of the superconducting layer obtained. The rare earth element represented by RE may be at least one element selected from the group consisting of Y, Gd, Dy, Ho, Er and Yb and includes, for example, $Y_zYb_{1-z}$ (z is a real number of $\emptyset$-1). The crystal structures of the above compounds have a common feature and they have a multi-layered perovskite structure.

The thickness of the superconducting layer may be determined depending upon the kind of superconducting oxide and the intensity of the magnetic field from which shielding is made. The thickness of the superconducting film or the superconducting layer of a superconducting device ranges from $3\emptyset\emptyset$ to $1,\emptyset\emptyset\emptyset$ $\mu$m, and preferably from $5\emptyset\emptyset$ to $1\emptyset\emptyset\emptyset$ $\mu$m. When the thickness is smaller than $3\emptyset\emptyset$ $\mu$m, it is difficult to obtain practically sufficient magnetic shieldability because leakage of magnetic field may take place via the very small through holes which may be generated in the superconducting layer. Hence, the thickness of the superconducting layer is preferably large. However, a thickness larger than $1,\emptyset\emptyset\emptyset$ $\mu$m is not preferable because such a large thickness gives rise to a temperature gradient in the thickness direction of the superconducting layer owing to the heating during the firing and dripping occurs at the portion of higher temperature, inviting reduction or variation in superconductivity in some cases.

In the present invention, a superconducting layer consisting of the above oxide superconducting material is formed on the intermediate layer of parts of a tube each consisting of a substrate and an intermediate layer, to obtain a structure of substrate-intermediate layer-superconducting layer. Alternatively, a superconducting layer is formed directly on a substrate when the substrate is a material (e.g. noble metal) having low reactivity with the oxide used in the superconducting layer.

A method of forming the superconducting layer is described. First, raw material oxide powders are mixed so as to give a composition of $Bi_2Sr_2CaCu_2O_x$ or $YBa_2Cu_3O_{7-y}$. The mixture is then calcined at a given temperature in the air, followed by grinding. The ground material is mixed with a magnesium oxide powder. The particle diameters of the magnesium oxide powder are not particularly restricted, but such a large particle size as to correspond to the thickness of the superconducting layer obtained is not preferable because the particles of such size act as defects themselves. Hence, the particle diameters of magnesium oxide are ordinarily in the range of $\emptyset.\emptyset 5$-$1\emptyset\emptyset$ $\mu$m with the average diameter in a range of $1$-$2\emptyset$ $\mu$m though it is varied depending upon the thickness of superconducting layer and the magnetic shieldability required for superconducting device for magnetic shielding.

Incidentally, magnesium oxide is presumed to act so as to increase the proportion of solid phase during the partial melting of superconducting oxide. Magnesium oxide alleviates the viscosity reduction of liquid phase at the partial melting temperature of superconducting oxide but has no contribution to the superconductivity of the superconducting layer obtained after firing.

The mixture of the ground material and magnesium oxide is made into a slurry in a solvent. An organic solvent is preferably used, and examples of the solvent include ethanol, ethylacetate, and toluene. The slurry may include a surfactant for dispersing the powders and a binder, such as polyvinylbutylalchohol.

The slurry is coated on a substrate or an intermediate layer laminated on the substrate, by a known method such as spray coating, brush coating, dip coating, doctor blade coating or the like to prepare a green film. Spray coating is employed ordinarily.

The green film is fired at a temperature at which the superconducting oxide is melted or partially melted, whereby a superconducting layer is formed. The temperature of firing is appropriately selected depending upon the type of the superconducting oxide used. For example, the temperature is $9\emptyset\emptyset$-$1,2\emptyset\emptyset°$ C when the superconducting oxide is $YBa_2Cu_3O_x$, and $87\emptyset$-$9\emptyset\emptyset°$ C when the superconducting oxide is $Bi_2Sr_2CaCu_2O_x$. Regardless of the type of the superconducting oxide used, the firing of the green film is preferably conducted in an atmosphere containing oxygen in a concentration of at least $2\emptyset\%$ or more preferably at least $8\emptyset\%$.

Conventionally viscosity of the melt of superconducting oxide in the green film sharply reduces at about the melting point thereof during the firing, which has caused the melt dripping. In contrast the green film of the present invention containing magnesium oxide, does not decrease its viscosity sharply at about the melting point of the superconducting oxide so that a thick superconducting layer or film forms without dripping.

In firing to prepare a large tube for shielding magnetic field, the tube is arranged with the longitudinal axis aligned in a vertical direction. In such arrangement in firing, it is very difficult to control in an ordinary electric furnace the temperature of a tube having a length of $5\emptyset$ cm or more such that the temperature difference in the longitudinal (vertical) direction becomes $2°$ C or less, and a temperature difference of about $6$-$1\emptyset°$ C commonly observed in the longitudinal axial direction. Thus, in firing the tube coated with a conventional green film, the green film tends to drip at the higher temperature portion of the tubular material owing to the sharp viscosity reduction of the superconducting oxide in the green film at about the melting point of the superconducting oxide; as a result, it has been impossible to obtain a satisfactory superconducting layer of uniform thickness. In contrast, when the firing temperature is set slightly lower than the partial melting of the oxide in order to prevent the green film from dripping, at the lower temperature portion of the tubular material oxide does not undergo sufficient partial melting; consequently, said portion comes to have significantly low superconductivity.

In contrast, the green film of the present invention does not have sharp viscosity reduction at partial melting temperatures of superconducting oxide during the firing so that superconducting layer of uniform thickness having satisfactory superconductivity forms, even when the tubular material has a temperature difference within itself during actual firing.

The present invention is hereinafter described in more detail by way of Examples. However, the present invention is not restricted thereto.

**Examples 1-5**

First, a substrate having a cylindrical shape of $1\emptyset\emptyset$ mm in outside diameter and $1,2\emptyset\emptyset$ mm in length was prepared using silver plates.

$Bi_2O_3$ powders, $SrCO_3$ powders, $CaCO_3$ powders and $CuO$ powders were mixed so as to give a composition of $Bi_2Sr_2CaCu_2O_x$. The mixture was calcined in the air at $83\emptyset$- $86\emptyset°$ C for at least $1\emptyset$ hours, followed by grinding to obtain calcined powders. To the calcined powders were added a given amount of magnesium oxide powders and ethyl alcohol as a solvent. The mixture was subjected to wet grinding and mixing together with $ZrO_2$ balls in a trommel to obtain a slurry of $Bi_2Sr_2CaCu_2O_x$. The amount of the magnesium oxide powders added was $1.\emptyset\%$ by weight in Examples 2 and 5, $\emptyset.5\%$ by weight in Example 1, $3.\emptyset\%$ by weight in Example 3 and $5.\emptyset\%$ by weight in Example 4.

The slurry was coated onto an outer surface the above cylindrical substrate by spray coating so as to become, after firing, a superconducting layer of given thickness. The thickness of superconducting layer after firing was $5\emptyset\emptyset$ μm in Examples 1-4 and $1,\emptyset\emptyset\emptyset$ μm in Example 5.

The thus obtained cylindrical material comprising a cylindrical silver substrate and a $Bi_2Sr_2CaCu_2O_x$ layer formed thereon, was placed in a furnace with the longitudinal axis aligned in a vertical direction and heated in a highly oxidizing atmosphere containing oxygen in a concentration of at least $9\emptyset\%$ at $88\emptyset$-$89\emptyset°$ C for $\emptyset.5$-$2.\emptyset$ hours to subject the $Bi_2Sr_2CaCu_2O_x$ on the cylindrical substrate to partial melting. Then, the cylindrical material was cooled slowly to $83\emptyset°$ C at a cooling rate of $\emptyset.5°$ C/min and heat-treated at $83\emptyset°$ C for at least $1\emptyset$ hours to crystallize grains of $Bi_2Sr_2CaCu_2O_x$ on the cylindrical substrate. Thereafter, the cylindrical material was slowly cooled to $7\emptyset\emptyset$ °C and, after the atmosphere was changed to a poorly oxidizing atmosphere consisting of nitrogen and up to 5% of oxygen, was heat-treated at $7\emptyset\emptyset$- $45\emptyset$ °C for at least 2 hours to obtain a cylindrical superconducting device for magnetic shielding, comprising a silver substrate and a $Bi_2Sr_2CaCu_2O_x$ layer formed directly thereon.

The cylindrical superconducting device for magnetic shielding had good appearance upon visual observation.

The surface of the cylindrical device was divided into squares each of $1\emptyset$ mm x $1\emptyset$ mm, and each square was measured at the center for critical current(Ic). The average of all local Ic and the minimum of all local Ic are put into the following formula, a local critical current (Ic) was evaluated, as a parameter for dispersion of local Ic in the cylinder was calculated. When the figure was $6\emptyset$ or larger, the distribution of local Ic was evaluated as o (good); when the figure was smaller than $6\emptyset$, the distribution of local J's was rated as X (bad).

$$Ic \text{ evaluation } = [\text{minimum local Ic/average local Ic}] \times 1\emptyset\emptyset$$

The above rating is called Ic evaluation in this specification. The distribution of local Ic in cylinder was satisfactory in all of Examples 1-5

The results are shown in Table 1.

## Table 1

| | amount of MgO added (wt %) | Layer thick- ness (μm) | Ic evalu- ation (%) | minimum local Ic (A/cm) | average local Ic (A/cm) |
|---|---|---|---|---|---|
| Example 1 | 0.5 | 500 | 89 | 81 | 91 |
| Example 2 | 1.0 | 500 | 89 | 80 | 90 |
| Example 3 | 3.0 | 500 | 93 | 77 | 83 |
| Example 4 | 5.0 | 500 | 86 | 65 | 76 |
| Example 5 | 1.0 | 1000 | 81 | 124 | 154 |
| Example 5' | 0.1 | 500 | 90 | 83 | 92 |

The superconducting layer was analyzied by scanning electron microscopy and X-ray microanalyzer. Particles containing magnesium was dispersed in a matrix of $Bi_2Sr_2CaCu_2O_x$ grains. Presumably magnesium did not substitute an element of $Bi_2Sr_2CaCu_2O_x$.

### Examples 6-11

In each of Examples 6-11, an Ag foil having a thickness of ∅.5 mm was laminated on an Inconel plate having a thickness of 2 mm to prepare a laminated member by diffusion bonding. These laminated members were connected by welding to form cylinders having short height. These small cylinders are welded to form the cylindrical wall of the substrate laminated with a silver layer. The cap of the laminated member is pressed to form a desired shape. A laminated tube having one open end and one closed end is thus obtained in which the Ag layer was located on the outer side of tube. The laminated tube has a generally cylindrical shape. The obtained tube had an outside diameter of 1∅∅ mm and a length of 12∅∅ mm.

A slurry of $Bi_2Sr_2CaCu_2O_x$ calcined powders and magnesium oxide powders dispersed in ethyl alcohol was prepared in the same manner as in Examples 1-5. The amount of the magnesium oxide powder used was 1.∅% by weight in Examples 7, 9, 1∅ and 11, ∅.5% by weight in Example 6 and 5.∅% by weight in Example 8.

The slurry was coated on the silver layer of the cylindrical laminated material prepared above, by spray coating so as to become, after firing, a superconducting layer of given thickness. The thickness of superconducting layer after firing was 5∅∅ μm in Examples 6-8 and 7∅∅ μm, 75∅ μm and 1,∅∅∅ μm in Examples 9, 1∅ and 11, respectively.

The subsequent firing and heat treatment were conducted in the same manner as in Examples 1-5 to obtain a cylindrical superconducting device for magnetic shielding, comprising an Inconel substrate, a silver layer formed thereon as an intermediate medium and a $Bi_2Sr_2CaCu_2O_x$ layer formed on the silver layer.

The cylindrical superconducting device for magnetic shielding had good appearance upon visual observation.

The cylindrical device was also subjected to Ic evaluation in the same manner as in Examples 1-5. The

7

distribution of local ic in cylinder was satisfactory in all of Examples 6-11.

The results are shown in Table 2.

## Table 2

| | amount of MgO added (wt %) | Layer thick- ness (μm) | Ic evalu- ation (%) | minimum local Ic (A/cm) | average local Ic (A/cm) |
|---|---|---|---|---|---|
| Example 6 | 0.5 | 500 | 90 | 82 | 91 |
| Example 7 | 1.0 | 500 | 88 | 79 | 90 |
| Example 8 | 5.0 | 500 | 82 | 62 | 76 |
| Example 9 | 1.0 | 700 | 70 | 81 | 116 |
| Example 10 | 1.0 | 750 | 77 | 92 | 119 |
| Example 11 | 1.0 | 1000 | 67 | 103 | 154 |

**Comparative Examples 1-3**

First, in Comparative Examples 1-2, a cylindrical substrate of 100 mm in outside diameter and 1,200 mm in length was prepared using silver, in the same manner as in Examples 1-5; in Comparative Example 3, there was prepared, in the same manner as in Examples 6-11, a cylindrical laminated material of 100 mm in outside diameter and 1,200 mm in length, comprising an Inconel substrate and a silver layer (to become an intermediate medium later) formed thereon.

A slurry of a $Bi_2Sr_2CaCu_2O_x$ calcined powder dispersed in ethyl alcohol was prepared in the same manner as in Examples 1-11. In this case, the slurry contained no magnesium oxide powder unlike in Examples.

The slurry was coated on the silver layer of the cylindrical laminated material prepared above, by spray coating so as to become, after firing, a superconducting layer of given thickness. The thickness of superconducting layer after firing was 500 μm, 700 μm and 600 μm in Comparative Examples 1, 2 and 3, respectively.

The subsequent firing and heat treatment were conducted in the same manner as in Examples 1-11 to obtain a cylindrical superconducting device for magnetic shielding, having a $Bi_2Sr_2CaCu_2O_x$ layer as the outermost layer.

The cylindrical superconducting device for magnetic shielding had noticeable dripping and gave bad appearance upon visual observation. The cylindrical device was also subjected to Ic evaluaation in the same manner as in Examples 1-5. The distribution of local Ic in cylinder was not satisfactory in any of Comparative Examples 1-3.

The results are shown in Table 3.

## Table 3

| | amount of MgO added (wt %) | Layer thick-ness (μm) | Ic evalu-ation (%) | minimum local Ic (A/cm) | average local Ic (A/cm) |
|---|---|---|---|---|---|
| Comparative Example 1*a | 0 | 500 | 3 | 3 | 93 |
| Comparative Example 2*a | 0 | 700 | 1 | 1 | 123 |
| Comparative Example 3*b | 0 | 600 | 5 | 5 | 108 |

*a: silver substrate

*b: Inconel substrate and silver intermediate layer

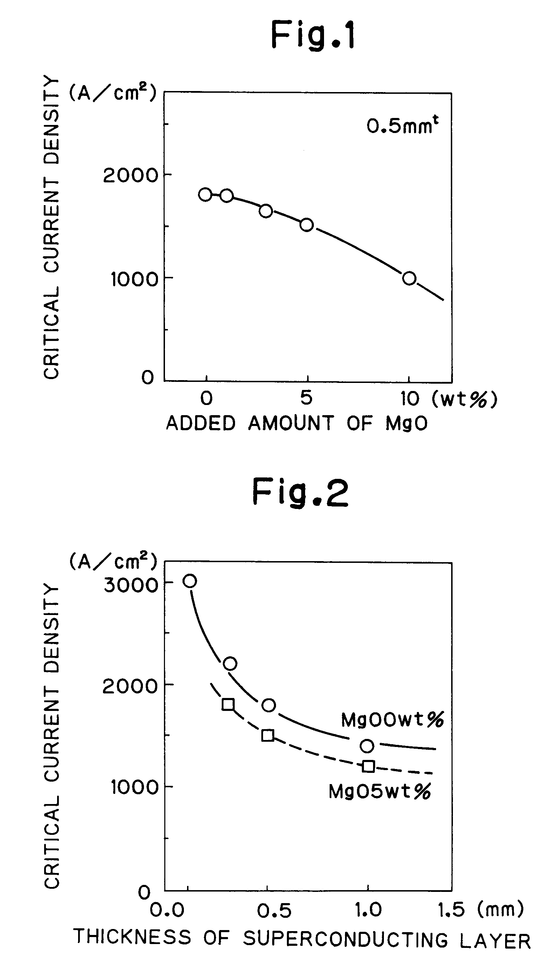

Fig. 1 is a graph showing a relation between critical current density Jc (A/cm$^2$) and amount (wt. %) of magnesium oxide added, in a rectangular test piece of 5∅ mm in length and 5 mm in width, comprising a silver substrate and a superconducting layer of $Bi_2Sr_2CaCu_2O_x$. The critical current density Jc (A/cm$^2$) decreases with the increase of the amount (wt. %) of magnesium oxide added in the superconducting layer.

Fig. 2 is a graph showing relations between critical current density Jc (A/cm$^2$) and thickness (μm) of superconducting layer, in (a) a test piece of 5∅ mm in length and 5 mm in width, comprising a silver substrate and a superconducting layer consisting of $Bi_2Sr_2CaCu_2O_x$ and 5% by weight of magnesium oxide and (b) a test piece of the same dimension, comprising the same silver substrate and a superconducting layer consisting of $Bi_2Sr_2CaCu_2O_x$ alone and containing no magnesium oxide. In both test pieces, i.e. both when 5% by weight of magnesium oxide is contained and when no magnesium oxide is contained, the critical current density Jc (A/cm$^2$) decreases with the increase of the thickness (μm) of superconducting layer.

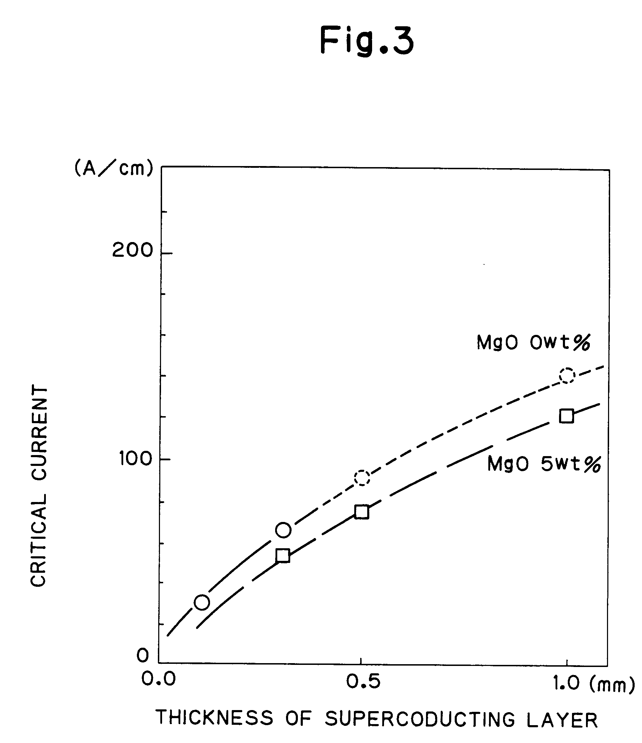

This decrease of critical current density is sufficiently supplemented by the increase of critical current Ic (A/cm) with the increase of the thickness of superconducting layer. Fig. 3 is a graph showing relations between critical current Ic (A/cm) and the thickness (μm) of superconducting layer, in (1) a cylindrical superconducting device for magnetic shielding of 1∅∅ mm in outside diameter and 1,∅∅∅ mm in length (height), comprising a cylindrical silver substrate and a superconducting layer consisting of $Bi_2Sr_2CaCu_2O_x$ and 5% by weight of magnesium oxide (this device meets the claim of the present invention) and (2) a cylindrical superconducting device for magnetic shielding of the same dimension, comprising the same silver substrate and a superconducting

layer consisting of $Bi_2Sr_2CaCu_2O_x$ alone and containing no magnesium oxide. When these cylindrical devices were produced, the highest-lowest temperature difference in cylinder during firing was 6° C. In the cylindrical device (2) whose superconducting layer contained no magnesium oxide, dripping was noticeable when the thickness of the superconducting layer was 5ØØ μm or larger, and there could be obtained no cylindrical device having a superconducting layer of such a thickness. Hence, the two Ic values of the cylindrical device (2) corresponding to thicknesses Ø.5 mm and 1.Ø mm were estimated from the dotted line of Fig. 2.

As is clear from Fig. 3, a cylindrical superconducting device for magnetic shielding, comprising a superconducting layer having a thickness of 5ØØ μm or more, which meets the claim of the present invention, could be obtained by adding magnesium oxide to said superconducting layer. The decrease of critical current density due to the addition of magnesium oxide or due to the increase of the thickness of superconducting layer can be sufficiently supplemented by the increase of critical current with the increase of the thickness of superconducting layer. That is, the critical current obtained by the increase of the thickness of superconducting layer due to the addition of magnesium oxide is larger than the critical current obtained when no magnesium oxide is added.

In the conventional formation of superconducting layer by firing a green film containing a calcined powder of superconducting oxide, there has occurred the sharp viscosity reduction of the green film at about the melting point of the superconducting oxide, which has caused dripping, etc. Therefore, the thickness of the superconducting layer obtained has been restricted. In contrast, with the green film used in the present invention, comprising magnesium oxide and a calcined powder of superconducting oxide, the viscosity of the green film is higher at about the melting point of the superconducting oxide than those experienced with conventional slurries.

Further, since the green film used in the present invention, comprising magnesium oxide and a calcined powder of superconducting oxide gives a viscosity higher than those of conventional green films at about the melting point of the superconducting oxide, it has become possible to produce a (tubular) superconducting device for magnetic shielding, whose superconducting layer has a thickness as large as 3ØØ-1,ØØØ μm as compared with the conventional thickness of 2ØØ-3ØØ μm. Furthermore, the present invention is particularly effective when a tubular material is fired with the longitudinal axis aligned in a vertical direction.

## Claims

1. A superconducting device comprising a substrate (21) and a superconducting oxide film (23) thereon, said superconducting film having a thickness in the range from 300 to 1000 μm and containing 0,1-5% by weight of magnesium oxide.

2. A superconducting device according to claim 1 having a Bi-Sr-Ca-Cu-O type superconducting oxide having a multi-layered perovskite structure as the main component of said superconducting film.

3. A superconducting device according to claim 2 wherein said Bi-Sr-Ca-Cu-O type oxide is $Bi_2Sr_2CaCu_2O_x$.

4. A superconducting device according to any one of claims 1 to 3 which is a magnetic shield, said superconducting layer having a critical temperature higher than -196°C.

5. A superconducting device in the form of a magnetic shield according to claim 4, wherein said substrate has a tubular shape.

6. A superconducting device in the form of a magnetic shield according to claim 4 or claim 5 wherein an intermediate layer (22) essentially consisting of a noble metal is present on said substrate (21) between said substrate and said superconducting film (23).

7. A process of producing a superconducting device, which comprises the step of firing, on a substrate, a mixture of calcined powder of a superconducting oxide composition and 0.1-5% by weight of magnesium oxide powder at a temperature at which said superconducting oxide is partially melted, to form a superconducting oxide film on said substrate with a thickness in the range 300 to 1000 μm.

8. A process according to claim 7 wherein the device is for magnetic shielding and said substrate has a tubular shape.

9. A process according to claim 8 wherein said firing step is conducted when said substrate is arranged with its longitudinal axis extending in a vertical direction.

10. A process according to any one of claims 7 to 9 wherein said superconducting film has a Bi-Sr-Ca-Cu-O type superconducting oxide having a multi-layered perovskite structure as its main component.

11. A process according to claim 10 wherein said Bi-Sr-Ca-Cu-O type oxide is $Bi_2Sr_2CaCu_2O_x$.

**Patentansprüche**

1. Supraleitende Vorrichtung, die ein Substrat (21) und einen supraleitenden Oxidifilm (23) darauf umfaßt, wobei der supraleitende Film eine Dicke im Bereich von 300 bis 1000 μm aufweist und 0,1-5 Gew.-% Magnesiumoxid enthält.

2. Supraleitende Vorrichtung nach Anspruch 1, die ein supraleitendes Oxid vom Bi-Sr-Ca-Cu-O-Typ mit einer mehrschichtigen Perowskitstruktur als Hauptkomponente des supraleitenden Films aufweist.

3. Supraleitende Vorrichtung nach Anspruch 2, worin das Oxid vom Bi-Sr-Ca-Cu-O-Typ $Bi_2Sr_2CaCu_2O_x$ ist.

4. Supraleitende Vorrichtung nach einem der Ansprüche 1 bis 3, die eine magnetische Abschirmung ist, wobei die supraleitende Schicht eine kritische Temperatur über - 196°C aufweist.

5. Supraleitende Vorrichtung in Form einer magnetischen Abschirmung nach Anspruch 4, worin das Substrat rohrförmige Gestalt hat.

6. Supraleitende Vorrichtung in Form einer magnetischen Abschirmung nach Anspruch 4 oder 5, worin eine Zwischenschicht (22), die im wesentlichen aus einem Edelmetall besteht, auf dem Substrat (21) zwischen dem Substrat und dem supraleitenden Film (23) vorhanden ist.

7. Verfahren zur Herstellung einer supraleitenden Vorrichtung, welches den Schritt des Brennens eines Gemisches aus kalziniertem Pulver einer supraleitenden Oxidzusammensetzung und 0,1-5 Gew.-% Magnesiumoxidpulver auf einem Substrat bei einer Temperatur umfaßt, bei der das supraleitende Oxid teilweise geschmolzen wird, um auf dem Substrat einen supraleitenden Oxidfilm mit einer Dicke im Bereich von 300 bis 1000 μm auszubilden.

8. Verfahren nach Anspruch 7, worin die Vorrichtung zur magnetischen Abschirmung dient und das Substrat rohrförmige Gestalt aufweist.

9. Verfahren nach Anspruch 8, worin der Brennschritt durchgeführt wird, wenn das Substrat so angeordnet ist, daß sich seine Längsachse in vertikaler Richtung erstreckt.

10. Verfahren nach einem der Ansprüche 7 bis 9, worin der supraleitende Film ein supraleitendes Oxid vom Bi-Sr-Ca-Cu-O-Typ mit einer mehrschichtigen Perowskit-Struktur als seine Hauptkomponente aufweist.

11. Verfahren nach Anspruch 10, worin das Oxid vom Bi-Sr-Ca-Cu-O-Typ $Bi_2Sr_2CaCu_2O_x$ ist.

**Revendications**

1. Dispositif supraconducteur, comprenant un substrat (21) et un film (23) d'oxyde supraconducteur sur celui-ci, ledit film supraconducteur ayant une épaisseur dans l'intervalle de 300 à 1000 μm et contenant de 0,1 à 5% en poids d'oxyde de magnésium.

2. Dispositif supraconducteur selon la revendication 1, ayant un oxyde supraconducteur du type Bi-Sr-Ca-Cu-O, ayant une structure pérovskite multicouche en tant que composant principal dudit film supraconducteur.

3. Dispositif supraconducteur selon la revendication 2, dans lequel ledit oxyde de type Bi-Sr-Ca-Cu-O est du $Bi_2Sr_2CaCu_2O_x$.

4. Dispositif supraconducteur selon l'une quelconque des revendications 1 à 3, qui est un écran magnétique, ladite couche supraconductrice ayant une température critique supérieure à -196°C.

5. Dispositif supraconducteur sous la forme d'un écran magnétique selon la revendication 4, dans lequel ledit substrat a une forme tubulaire.

6. Dispositif supraconducteur sous la forme d'un écran magnétique selon la revendication 4 ou 5, dans lequel une couche intermédiaire (22) consistant essentiellement d'un métal noble est présente sur ledit substrat (21) entre ledit substrat et ledit film (23) supraconducteur.

7. Dispositif de production d'un dispositif supraconducteur, qui comprend l'étape de calcination, sur un substrat, d'un mélange d'une poudre calcinée d'une composition d'oxyde supraconducteur et de 0,1 à 5% en poids de poudre d'oxyde de magnésium à une température à laquelle ledit oxyde supraconducteur est partiellement fondu, pour former un film d'oxyde supraconducteur sur ledit substrat avec une épaisseur dans l'intervalle de 300 à 1000 μm.

8. Procédé selon la revendication 7, dans lequel le dispositif est pour faire écran magnétique et ledit substrat a une forme tubulaire.

9. Procédé selon la revendication 8, dans lequel ladite étape de calcination est menée lorsque ledit substrat est situé avec son axe longitudinal s'étendant dans une direction verticale.

10. Procédé selon l'une quelconque des revendications 7 à 9, dans lequel ledit film supraconducteur a un oxyde supraconducteur de type Bi-Sr-Ca-Cu-O ayant une structure pérovskite multicouche en tant que son composant principal.

11. Procédé selon la revendication 10, dans lequel ledit oxyde de type Bi-Sr-Ca-Cu-O est du $Bi_2Sr_2CaCu_2O_x$.

# Fig.1

# Fig.2

# Fig.3

# Fig.4

# Fig.5